# EUROPEAN PATENT APPLICATION

(11) **EP 2 216 881 A1**
(43) Date of publication of application: **11.08.2010**
(21) Application number: 08852401.2
(22) Date of filing: 20.11.2008
(51) Int. Cl.: H02J 13/00, G01R 11/00, G01R 22/00, G06Q 50/00

(54) **ENERGY MANAGEMENT SYSTEM**

(30) Priority: 20.11.2007 JP 2007301049
(71) Applicant: Panasonic Electric Works Co., Ltd, Kadoma-shi Osaka 571-8686 (JP)
(72) Inventor: MAEDA, Yuko, Kadoma-shi Osaka 571-8686 (JP); MORIMOTO, Naohisa, Kadoma-shi Osaka 571-8686 (JP); TAKAMIYA, Akiko, Kadoma-shi Osaka 571-8686 (JP)
(74) Representative: Appelt, Christian W.
(86) International application number: PCT/JP2008/071154
(87) International publication number: WO 2009/066742

(57) **Abstract**

The energy management system capable of increasing consciousness of a user for energy saving and inducing the user to act for the energy saving by means of providing energy-saving information is provided. In the energy management system, a center device **V** includes an information database where bits of knowledge are successively stored as energy-saving information. Upon receiving a display request to display a display screen for displaying the bits of knowledge from a terminal device such as a display control device **CV,** a personal computer **PC,** and a portable terminal **PT,** the center device **SV** generates image data of the display screen for displaying the bits of knowledge and transmits the same to the terminal device that is a requestor of the display screen. The terminal device displays the image data received from the center device **SV.**

## Description

### Technical Field

The present invention relates to an energy management system.

### Background Art

A variety of energy management systems have heretofore been provided. As one embodiment of the energy management system, JP 3551302 discloses an electrical power monitoring system. The electrical power monitoring system can display household power consumption (e.g. main electrical energy at a distribution board). Further, the electrical power monitoring system can compare the household power consumption with power consumption of other homes and display a comparison result. As seen in the above, the electrical power monitoring system is capable of displaying the power consumption as well as the comparison result with other homes. Accordingly, it is possible to increase consciousness of a user for energy saving.

However, the electrical power monitoring system only displays the power consumption or the like. In order to achieve the energy saving, a user needs to consider and search a method of energy saving by oneself. This bothers the user extremely. Accordingly, there is a difficulty that a probability of making an actual act for the energy saving is low.

### Disclosure of Invention

In view of above insufficiency, the purpose of the present invention has been accomplished to provide an energy management system capable of increasing consciousness of a user for energy saving and prompting the user to act for the energy saving.

The energy management system in accordance with the present invention includes a home appliance located in a home and a terminal device connected to the home appliance. The home appliance includes a current measurement unit, an electrical energy calculation unit, and a processing unit. The current measurement unit is configured to measure a current flowing through each branch breaker connected to an output terminal of a main breaker. The electrical energy calculation unit is configured to calculate electricity usage at each of the branch breakers on the basis of a measurement of the current measurement unit. The processing unit is configured to generate information of electricity usage at the home on the basis of the electric usage calculated by the electrical energy calculation unit. The terminal device includes a display unit adapted in the use of displaying the information of the electricity usage generated by the processing unit. The energy management system includes a server connected to the home appliance via an outside network. The server includes a storage unit and an information transmission unit. The storage unit is configured to store energy-saving information including information indicative of a method of energy saving. The information transmission unit is configured to transmit the energy-saving information stored in the storage unit to the terminal device.

According to the present invention, the energy management system displays the energy-saving information. Accordingly, it is possible to increase consciousness of a user for energy saving. Moreover, it is possible to prompt the user to act for the energy saving, because the energy-saving information includes the information indicative of the method of the energy saving. As a result, the energy saving can be sufficiently improved.

In the preferred embodiment, the information transmission unit is configured to transmit the energy-saving information to the terminal device at a prescribed timing.

According to this embodiment, it is possible to display the energy-saving information on the terminal device even when the user has no access to the server.

In the preferred embodiment, the information transmission unit is configured to transmit the energy-saving information to the terminal device in response to a request from the terminal device.

According to this embodiment, the user can view the energy-saving information at any desired time.

### Brief Description of Drawings

FIG. 1 is a block diagram illustrating the features of the energy management system of one embodiment of the present invention,
FIG. 2 is another block diagram illustrating the features of the aforementioned energy management system,
FIG. 3 is a system diagram illustrating the configuration of the aforementioned energy management system,
FIG. 4 shows an arrangement of components in an integrated control panel of the aforementioned energy management system,
FIG. 5 is a block diagram of the terminal device of the aforementioned energy management system,
FIG. 6 shows an example of a display screen of the terminal device of the aforementioned energy management system,
FIG. 7A shows an example of a display screen of the terminal device of the aforementioned energy management system,
FIG. 7B shows an example of a display screen of the terminal device of the aforementioned energy management system,
FIG. 8 shows an example of a display screen of the terminal device of the aforementioned energy management system,
FIG. 9 shows an example of a display screen of the terminal device of the aforementioned energy management system,
FIG. 10 shows an example of a display screen of the terminal device of the aforementioned energy management system,
FIG. 11A shows an example of a display screen of the terminal device of the aforementioned energy management system,
FIG. 11B shows an example of a display screen of the terminal device of the aforementioned energy management system, and
FIG. 12 shows an example of a display screen of another terminal device of the aforementioned energy management system.

### Best Mode for Carrying Out the Invention

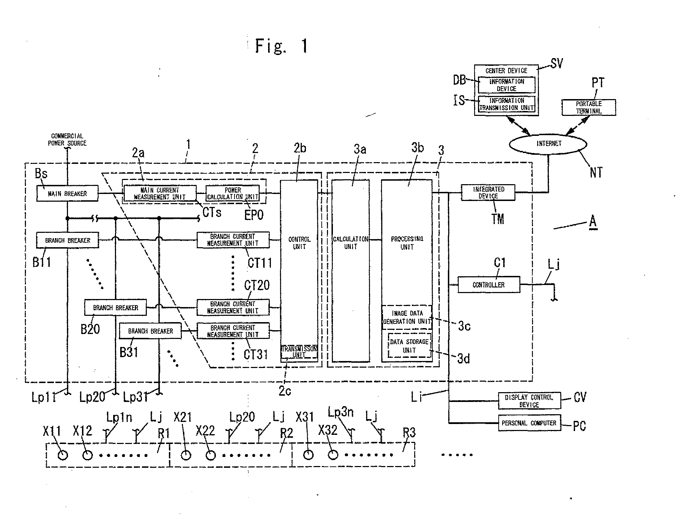

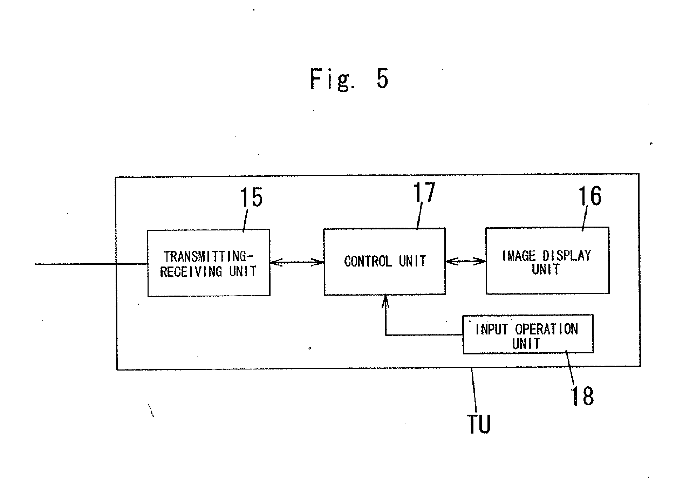

As shown in FIG. 1, the energy management system according to one embodiment of the present invention includes a home appliance **A** located in a home (a dwelling unit in the case of a housing complex), a terminal device **TU** (see FIG. 5) such as a personal computer **PC,** a display control device **CV,** and a portable terminal **PT,** and a center device (server) **SV** disposed outside the home. In this configuration, the center device **SV** is connected to the home appliance A via an internet **NT,** which is an external network (outside network).

The home appliance **A** includes an integrated control panel **1** disposed in the home and a plurality of electric apparatuses **Xmn** (symbols **m** and **n** are integers equal to or larger than 1; same hereinbelow) disposed in the home.

The electric apparatuses **Xmn** are connected to the integrated control panel **1** by a power line **Lp** that supplies commercial power and an information transmission line **Lj.** The electric apparatus **Xmn** can be illumination units, air conditioners, floor heating devices, and IH devices that are powered, controlled, and monitored by the integrated control panel **1.**

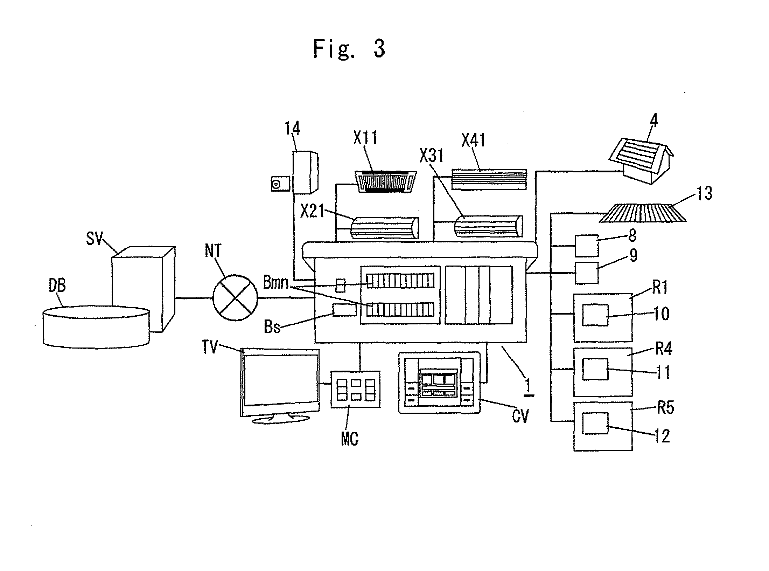

The personal computer **PC** and display control device **CV** are terminal devices having a web browser function and are disposed in the home. Such a terminal device (called hereinbelow, as necessary "a home terminal device") disposed in the home may also be a net television **TV** having a web browser function, as shown in FIG. 3. The net television **TV** is connected to the integrated control panel **1** via a multimedia outlet **MC.** The portable terminal **PT** is a terminal device having a web browser function that is connected to the center device **SV** by the internet **NT** and mainly taken out for use by the user (that is, used outside the home). The terminal device (called hereinbelow, as necessary "an outside terminal device") that is used outside the home may be a portable terminal device having a web browser function such as a notebook computer, a cellular phone, and a PDA (Personal Digital Assistance) that can be connected to the internet **NT.**

In the present embodiment, a home network using a typical communication protocol (TCP/IP, HTTP, or the like) is constituted by the integrated control panel **1** and the home terminal device. The home network is a local area network (LAN) conforming to a 100BASE-TX (IEEE 802.3u) standard. In the home network, the home terminal device corresponding to a network terminal is connected by a star wiring to the below-described integrated device **TM** corresponding to a layer 2 switch or a layer 3 switch inside the integrated control panel **1.**

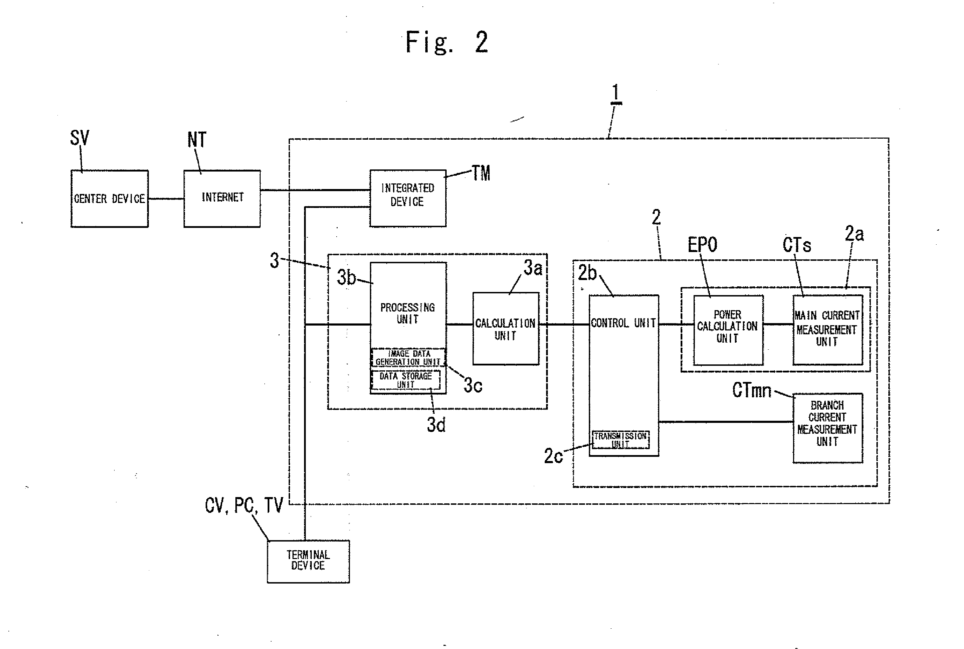

As shown in FIG. 1 and FIG. 2, the integrated control panel **1** includes a main breaker **Bs,** a plurality (only three are shown in FIG. 1) of branch breakers **Bmn (m =** 1, 2,.... **n** = 1, 2, ...), a current measurement unit **2,** an energy management unit **3,** the aforementioned integrated device **TM,** and an electric device controller **C1.**

A power supply line for commercial power supply that is drawn into the home from the outside (external power generation equipment or the like) is connected to the input terminal of the main breaker **Bs.** The main electric circuit (main line) is connected to the output terminal of the main breaker **Bs.** A plurality of electric lines **Lpmn** (**m** = 1, 2, ..., **n** = 1, 2, ...) that are branch electric lines (branch lines) for supplying power to the electric apparatuses **Xmn** are branched off the main electric line. The eclectic lines **Lpmn** are led out to the outside from the integrate control panel **1,** and the electric apparatuses **Xmn** are connected to the electric lines **Lpmn.** Therefore, power is supplied to the electric apparatuses **Xmn** through the electric lines **Lpmn.** The branch breakers **Bmn** are inserted between the electric lines **Lpmn** and the electric apparatuses **Xmn.**

For example, a plurality of rooms **Rm** (**m** =1, 2, ...) such as a living room, a bedroom, and a children's room are provided in the home. Each room **Rm** is provided with the respective electric apparatus **Xmn** (**m** = 1, 2, ..., **n =** 1, 2, ...) or with an outlet for connection of electric apparatuses **Xmn.**

In the present embodiment, as shown in FIG. 1 and FIG. 3, an air conditioner **X11** or an outlet **10** (an outlet for connection of electric apparatuses **Xmn** that are used inside the room **R1,** the electric apparatuses being other than the air conditioner **X11**) provided in the room **R1** (for example, a living room) are connected to the branch breakers **B1n** (**n** = 1, 2, ...). Power is supplied to the air conditioner **X11** or outlet **10** via the corresponding electric line **Lp1n** (n = 1, 2, ...). An air conditioner **X21** provided in the room **R2** (for example, a children's room) is connected to the branch breaker **B20.** Power is supplied to the air conditioner **X21** via the electric line **Lp20.** Further, an air conditioner **X31** provided in the room **R3** (for example, a bedroom) is connected to the branch breaker **B31.** Power is supplied to the air conditioner **X31** via the electric line **Lp31.** Further, an air conditioner **X41** or an outlet **8** for a refrigerator provided in the room **R4** (for example, a kitchen) is connected to the branch breaker **B4n** (n = 1, 2, ...). Power is supplied to the air conditioner **X41** or outlet **8** via the corresponding electric line **Lp4n** (**n** = 1, 2, ...). Further, an outlet **11** (an outlet for connection of the electric apparatus used in the room **R5**) provided in the room **R5** (for example, a Japanese room) is connected to the branch breaker **B51.** Power is supplied to the outlet **11** via the electric line **Lp51.** Further, a water heater **14,** a floor heater **13,** and an outlet **9** for a washing machine are connected to branch breakers **Bmn** (**m** = 6, 7, ..., **n** = 1, 2, ...). Power is supplied to the water heater **14,** floor heater **13,** and outlet **9** via the corresponding electric lines **Lpmn** (**m** = 6, 7, ..., **n** = 1, 2, ...).

The current measurement unit **2** is configured to measure a current flowing in the main breaker **Bs** and the branch breakers **Bmn.** More specifically, the current measurement unit **2** is provided with a main power measurement unit **2a,** branch current measurement units **CTmn** (**m** = 1, 2, ..., **n** = 1, 2, ...), and a control unit **2b.**

The main power measurement unit **2a** is configured to measure periodically main electrical energy supplied via the main breaker **Bs** (that is, electricity usage at the main breaker **Bs**). For example, the main power measurement unit **2a** is provided with a main current measurement unit **CTs** that measures periodically the main current flowing in the main breaker **Bs** and a power calculation unit **EPO** that calculates electrical energy on the basis of measured main current. Thus, in the main power measurement unit **2a,** the measured value of the main current measured by the main current measurement unit **CTs** is converted by the power calculation unit **EPO** into electrical energy, thereby calculating the main electrical energy supplied via the main breaker **Bs.**

The branch current measurement units **CTmn** measure periodically a value of a branch current flowing in each branch breaker **Bmn** for each branch breaker. For example, the branch current measurement unit **CTmn** is provided with a current sensor (not shown in the figure) that detects the branch current flowing in the electric line **Lpmn** and a sensor unit (not shown in the figure) that generates a detection data on the basis of the detection output of the current sensor. The sensor unit is configured to modulate the generated detection data into signals for transmission and output the modulated data to the control unit **2b.** Such branch current measurement units **CTmn** are provided for the branch breakers **Bmn,** respectively.

The control unit 2b collects the measurement data of the main power of the main breaker **Bs** and of the branch current of each branch breaker **Bmn.** Further, the control unit **2b** outputs the collected measurement data as detection information to the energy management unit **3.** More specifically, the control unit **2b** demodulates the transmission signal inputted from the sensor unit, extracts the detection data, and successively sends the acquired detection data from the transmission unit **2c** to the energy management unit **3.**

The energy management unit **3** is configured to calculate the electricity usage on the basis of measurement data inputted from the current measurement unit **2.** For example, the energy management unit **3** is provided with a calculation unit (electricity usage calculation unit) **3a** and a processing unit **3b.**

The calculation unit **3a** is configured to calculate branch electrical energy (that is, electricity usage at the branch breakers **Bmn**) supplied via the branch breakers **Bmn** on the basis of the measurement data of the branch current for each branch breaker **Bmn** received from the transmission unit **2c.**

The processing unit **3b** is connected via a LAN cable to the integrated device **TM** and electric apparatus controller **C1** located inside the integrated control panel **1**. The processing unit **3b** is configured to generate a screen data (e.g. a screen data for displaying the main electrical energy, a screen data for displaying the each branch electrical energy, and the like) displayed on the display control device **CV** on the basis of the main electrical energy and each branch electrical energy input from the calculation unit **3a.** Further, the processing unit **3b** has a web server function. The web server function of the processing unit **3b** is a function which generates web contents (web pages) as an image data for displaying the various electric usage such as the main electrical energy and the branch electrical energy for each branch electric line and transmits (sends) the desired web contents to the terminal device **TU** in response to a request from the terminal device **TU.**

The processing unit **3b** preliminarily stores a data (e.g. a name of the branch breaker: such as branch 1, branch 2, etc) of the branch breakers **Bmn** as a target of electrical energy detection. Further, the processing unit **3b** stores as the data of the branch breakers **Bmn** information of names of electric apparatuses **Xmn** connected to the branch breakers **Bmn** and the usage sites thereof. For example, concerning the branch breakers **Bmn** provided separately for individual circuits such as an air conditioner or floor heating equipment, the processing unit **3b** stores the names of corresponding electric apparatuses **Xmn.** Further, concerning the branch breakers **Bmn** that can be connected to unspecified electric apparatuses **Xmn,** rather than to individual circuits, the processing unit **3b** stores the names of electric apparatuses **Xmn** (for example, an illumination device, a television, a water heating device, etc.) that can be connected to the branch breakers **Bmn** or main usage sites. In this case, the names of electric apparatuses (for example, hot carpet or iron) **Xmn** that are highly probable to be connected to the branch breakers **Bmn** and used by the user and the usage sites of such apparatuses are preferably designated.

The aforementioned processing unit **3b** includes a data storage unit **3d** and an image data generation unit **3c.** The data storage unit **3d** preliminarily stores information (for example, application, installation site, or branch current during shut down) of the electric apparatuses **Xmn** connected to the branch breakers **Bmn.** Further, the main electrical energy inputted from the calculation unit **3a** and branch electrical energy for each branch breaker **Bmn** are successively stored in a time sequence in the data storage unit **3d.** Further, the data storage unit **3d** stores designation information of various kinds relating to power monitoring. The designation information is such as "Control Designation" and "Name Designation".

The image data generation unit **3c** is configured to generate the image data for displaying information of the electricity usage in the home (e.g. the various electric usage such as the main electrical energy and the branch electrical energy for each branch electric line) in response to various request signals inputted from the terminal device **TU** via the integrated device **TM,** and transmit (send) the generated image data to the terminal device **TU** that has sent the request signals.

The integrated device **TM** has an internet connection function corresponding to the type (telephone circuit, CATV circuit, optical fiber circuit, and the like) of the circuit for connecting to the internet **NT.** The home network is connected via the integrated device **TM** to the internet **NT,** which is the external network. Further, the integrated device **TM** also controls the exchange of data in the network and has a packet processing function, a path switching function, a network security function and a function of control point of UPnP (Universal Plug and Play).

In the present embodiment, the integrated device **TM** is connected to the processing unit **3b** of the energy management unit **3** located in the integrated control panel **1** or the electric apparatus controller **C1,** personal computer **PC** outside the integrated control panel **1,** and display control device **CV** via a LAN cable (LAN cable of enhanced category 5 or category 6). Further, the integrated device **TM** is connected to the center device **SV** or the portable terminal **PT** or another terminal device via the internet **NT.** Therefore, the center device **SV** is connected to the home network via the internet **NT.** As a result, by conducting data communication between the portable terminal **PT** and the center device **SV** via the internet **NT,** it is possible to control or monitor the electric apparatuses **Xmn** inside the home from an outside address by using the portable terminal **PT.**

The electric apparatus controller **C1** has an interface function for the integrated device **TM** and an interface function for the electric apparatuses **Xmn** conforming to a unified standard of The Japan Electrical Manufacturers' Association (JEMA). Further, the electric apparatus controller **C1** has a function (control function) of controlling individually the electric apparatuses **Xmn** via the information transmission path **Lj** and switching between active and inactive state of the apparatuses when the electric apparatus controller **C1** receives a control request message from the terminal device **TU** via the integrated device **TM.** In addition, the electric apparatus controller **C1** has a monitoring function. The monitoring function is a function of individually obtaining the operation state (operates "Light ON" or stopped "Light OFF") of each electric apparatus Xmn via the information transmission line **Lj** when a monitoring request message is received from the terminal device **TU** via the integrated device **TM** and transmitting a message (operation state of each electric apparatus **Xmn**) in response to the control request or monitoring request to the terminal device **TU** that is a transmission source of the monitoring request message. Further, the apparatus name information of the electric apparatuses **Xmn** that are under autonomous control and name information rooms **Rm** is stored preliminarily in the electric apparatus controller **C1.** In addition, the electric apparatus controller **C1** has a web server function. The web server function is a function of creating web contents (web page) for representing the name and also the operation state of the electric apparatuses **Xmn** by text or symbols and providing (distributing) the web contents to the terminal device TU in response to a request from the terminal device **TU.**

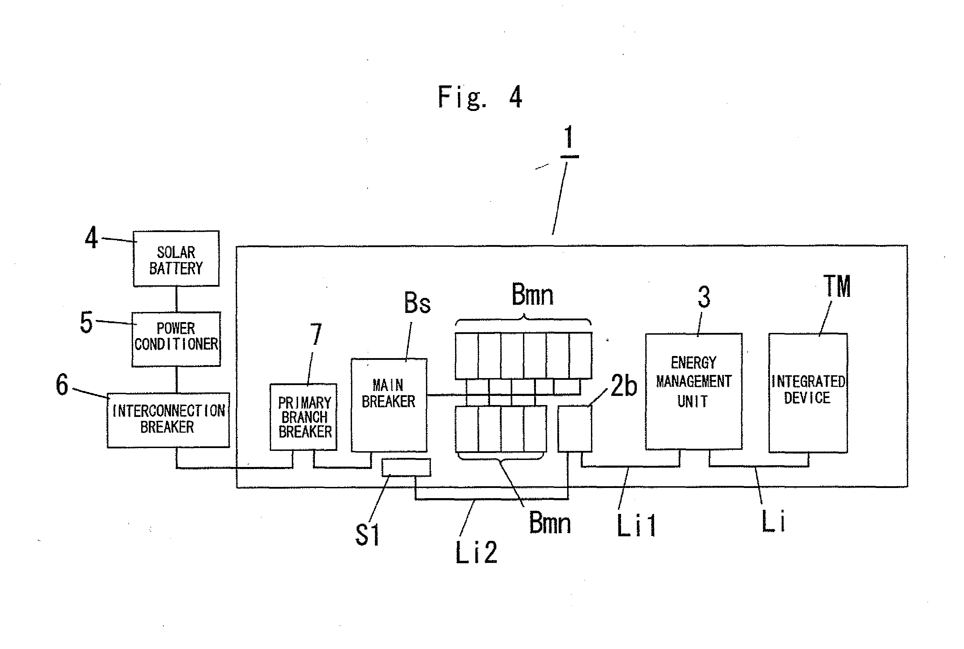

FIG. 4 shows an arrangement of the main breaker **Bs,** branch breakers **Bmn,** control unit **2b** constituting the current measurement unit **2,** energy management unit **3,** and integrated device **TM** in the integrated control panel **1.** A plurality of the branch breakers **Bmn** is arranged in two, upper and lower, rows and disposed in the transverse direction to the right of the main breaker **Bs.** The control unit **2b** is disposed to the right of the branch breakers **Bmn.** A main power measurement sensor **S1** constituting the main power measurement unit **2a** is disposed below the main breaker **Bs.** The main power measurement sensor **S1** is connected by a communication cable **Li2** (for example, RS485 or the like) to the control unit **2b.** Therefore, the main electrical energy of the main breaker **Bs** measured by the main power measurement sensor **S1** is inputted via the communication cable **Li2** to the control unit **2b.** Further, the energy management unit **3** is disposed to the right of the control unit **2b.** The integrated device **TM** is disposed to the right of the energy management unit **3.** The energy management unit **3** is connected to the integrated device **TM** by the LAN cable **Li** and connected to the control unit **2b** by a communication cable **Li1** (for example, RS485 or the like). Therefore, the measurement data of the main power of the main breaker **Bs** and the measurement data of the branch current of each branch breaker **Bmn** transmitted from the transmission unit **2c** of the control unit **2b** are inputted via the communication cable **Li1** to the energy management unit **3.**

In the present embodiment, as shown in FIG. 4, power can be also supplied from a solar battery **4** using solar energy, rather than only from the commercial power supply. The solar battery **4** is a DC power source in the form of a panel in which a large number of solar cells (elements that photoelectrically convert solar energy into electrical energy). The DC power generated by the solar battery **4** is converted by a power conditioner **5** into AC power and supplied to a load via a system breaker **6** and a primary branch breaker **7** in combination with the commercial power.

The center device **SV** is constituted by a typical computer device having a network function. The center device **SV** has a function (relay function) of relaying a message addressed to the integrated control panel **1** that is transmitted by the portable terminal **PT** via the internet **NT** or a message addressed to the terminal device (e.g. the portable terminal **PT** or the like) not belonging to the home network that is transmitted by the integrated control panel **1.** Further, the center device **SV** includes an information database (storage unit) **DB** and an information transmission unit. The information database **DB** is configured to store energy-saving information. The energy-saving information includes bits of knowledge (bits of knowledge concerning energy-saving). The bits of knowledge includes information indicative of a method of energy saving. The method of energy saving is, such as "turn off master switch of television", "decrease preset temperature of air conditioner by 1 degree", and the like. The aforementioned bits of knowledge (for example, the monthly bits of knowledge) are successively saved in the information database **DB.** The information transmission unit is configured to transmit to the terminal device **TU** the energy-saving information (in the present embodiment, the bits of knowledge) stored in the information database **DB.**

The information transmission unit of the present embodiment has a push-type information providing function and a pull-type information providing function. The push-type information providing function is a function of transmitting at a predetermined timing the bits of knowledge to an information reception unit of the terminal device **TU.** Meanwhile, the pull-type information providing function is a function of transmitting, in response to an information request message from the information reception unit, the bits of knowledge to the information reception unit that has transmitted the information request message.

As shown in FIG. 5, the terminal device **TU** is provided with a transmitting-receiving unit **15**, an image display unit (display unit) **16** composed of a liquid crystal display, an input operation unit **18,** and a control unit **17** that conducts complete control of the transmitting-receiving unit **16**, image display unit **16,** and input operation unit **18.** The transmitting-receiving unit **15** serves to exchange data with the integrated device **TM.** The input operation unit **18** serves to input operation signals. For example, when the terminal device **TU** is the display control device **CV,** the input operation unit **18** is a touchpad disposed on the front surface of the image display unit **16** and together with the image display unit **16** constitutes a touch panel. When the terminal unit **TU** is the personal computer PC or portable terminal **PT,** the input operation unit **18** is constituted by a keyboard or ten keys.

Further, the terminal device **TU** includes the aforementioned information reception unit. The information reception unit is configured to, upon receiving the bits of knowledge from the information transmission unit of the center device **SV,** control the image display unit **16** to display the received bits of knowledge. The information reception unit is configured to transmit the information request message to the center device **SV** in response to a request from the user. The aforementioned information reception unit is constituted by the transmitting-receiving unit 15, the image display unit **16,** the control unit **17,** and the input operation unit **18.**

As described in the above, the energy management system of the present embodiment displays the energy-saving information. Accordingly, it is possible to increase consciousness of a user for energy saving. Moreover, it is possible to prompt the user to act for the energy saving, because the energy-saving information includes the method of the energy saving. As seen from the above, the user acting continuously for the energy saving can sufficiently improve the energy saving.

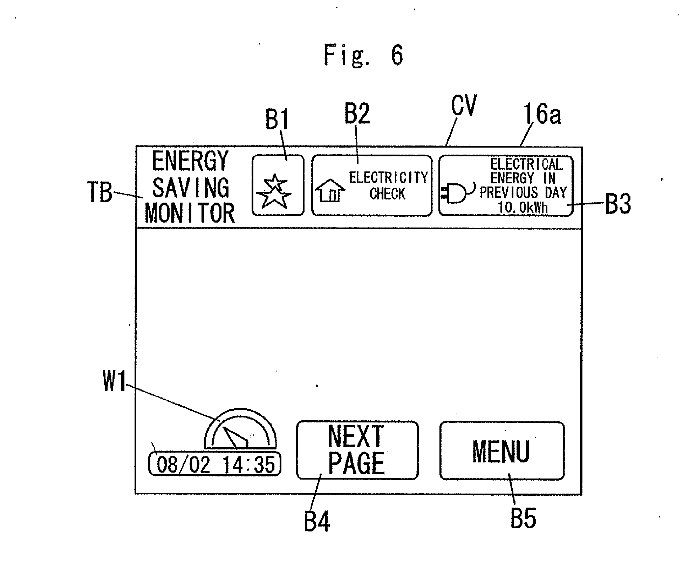

An operation example of the energy management system of the present embodiment is explained below with reference to FIG. 6 to FIG. 10. Particularly, an operation of providing the bits of knowledge from the center device **SV** to the terminal device **TU** is explained.

FIG. 6 shows an example of a screen that is displayed on a display screen **16a** when the display control device **CV** is activated or when the display control device **CV** is switched from an intermediate screen to a top screen. A title bar **TB** indicating a screen name (in the present embodiment, "Energy Saving Monitor") is displayed in the upper portion of the screen shown in FIG. 6. Further, in the screen shown in FIG. 6, an electricity consumption display button **B1,** an electric check button **B2,** and a comparison result display button **83** are displayed to the right of the title bar **TB.** The electricity consumption display button **B1** serves to switch from the screen shown in FIG. 6 to a screen displaying electricity consumption. The electric check button **B2** serves to switch from the screen shown in FIG. 6 to a screen displaying a usage state of electric apparatuses, The comparison result display button **B3** serves to switch from the screen shown in FIG. 6 to a screen displaying a comparison result of the electricity usage. A display section **W1** that displays the electricity usage in the current day is disposed in the lower section of the screen shown in FIG. 6. A next page button **B4** for moving to the next page and a menu button **B5** for moving to a menu screen are also displayed in the lower portion of the screen shown in FIG. 6.

When the user selects the menu button **B5,** the control unit **17** of the display control device **CV** controls the transmitting-receiving unit **15** so as to transmit a display request to display the menu screen to the energy management unit 3 via the integrated device **TM.** Upon receiving the display request, the energy management unit **3** transmits a webpage for displaying the menu screen to a transmission source of the display request (that is, the display control device **CV** which has transmitted the display request). As a result, the webpage received by the transmitting-receiving unit **15** is displayed on the display screen **16a** of the display control device **CV.**

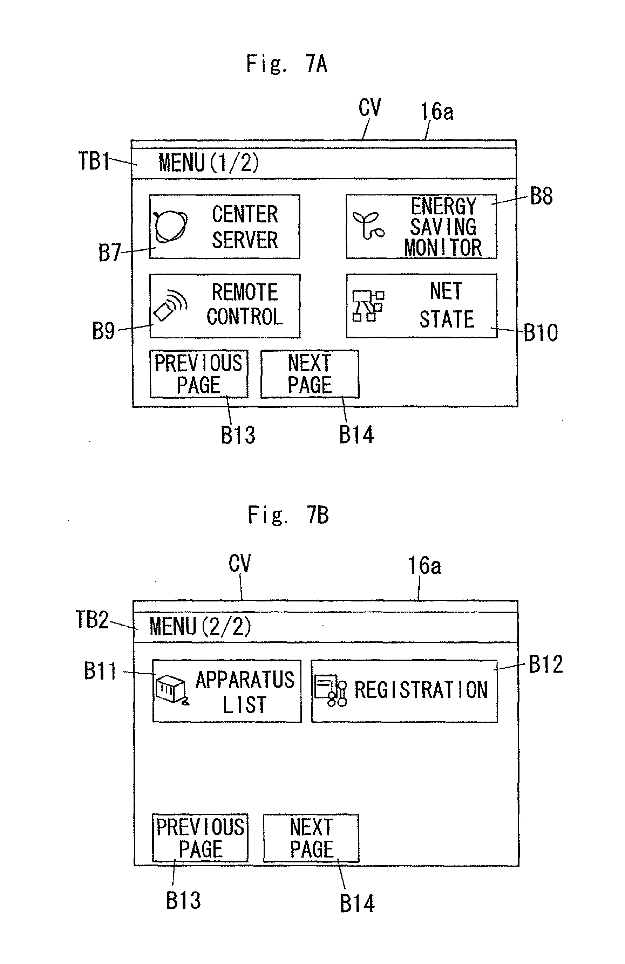

FIGS. 7A and 7B show an example of the menu screen displayed on the display screen **16a** of the display control device **CV.** A title bar **TB1** indicating a screen name (in FIG. 7A, "menu (1/2)") is displayed in the upper portion of the screen shown in FIG. 7A. Menu selection buttons **B1** to **B10** for selecting a desired menu are displayed in the center of the screen shown in FIG. 7A. A previous page button **B13** and a next page button **B14** for moving to the previous page or next page are displayed in the lower portion of the screen shown in FIG. 7A. The text ("Center Server", "Energy Saving Monitor", "Remote Control", and "Net State") that indicates corresponding menu contents is displayed on the respective menu selection buttons **B7** to **B10.**

Meanwhile, a title bar **TB2** indicating a screen name (in FIG. 7B, "menu (2/2)") is displayed in the upper portion of the screen shown in FIG. 7B. Menu selection buttons **B11** and **B12** for selecting a desired menu are displayed in the center of the screen shown in FIG. 7B. A previous page button **B13** and a next page button **B14** for moving to the previous page or next page are displayed in the lower portion of the screen shown in FIG. 7B in the same manner as the screen shown in FIG. 7A. The text ("Apparatus List" and "Registration") that indicates corresponding menu contents is displayed on the respective menu selection buttons **B11** and **B12.**

When the next page button **B14** is selected on the screen shown in FIG. 7A, the screen shown in FIG. 7B is displayed on the display screen **16a** by means of processing similar to that described above. Meanwhile, where the previous page button **B13** is selected on the screen shown in FIG. 7B, the menu screen, which is the screen shown in FIG. 7A, is displayed on the display screen **16a** by means of processing similar to that described above.

The aforementioned menu selection button **B7** serves to switch from the screen shown in FIG. 7A to a screen provided by the center device **SV.** When the menu selection button **B7** is selected, the control unit **17** of the display control device **CV** controls the transmitting-receiving unit **15** so as to transmit a display request to display a menu screen to the center device **SV** via the integrated device **TM.** Upon receiving the display request via the integrated device **TM,** the center device **SV** transmits a webpage for displaying the menu screen to a transmission source of the display request (the display control device **CV** which has transmitted the display request). As a result, the webpage received by the transmitting-receiving unit **15** is displayed on the display screen **16a** of the display control device **CV.**

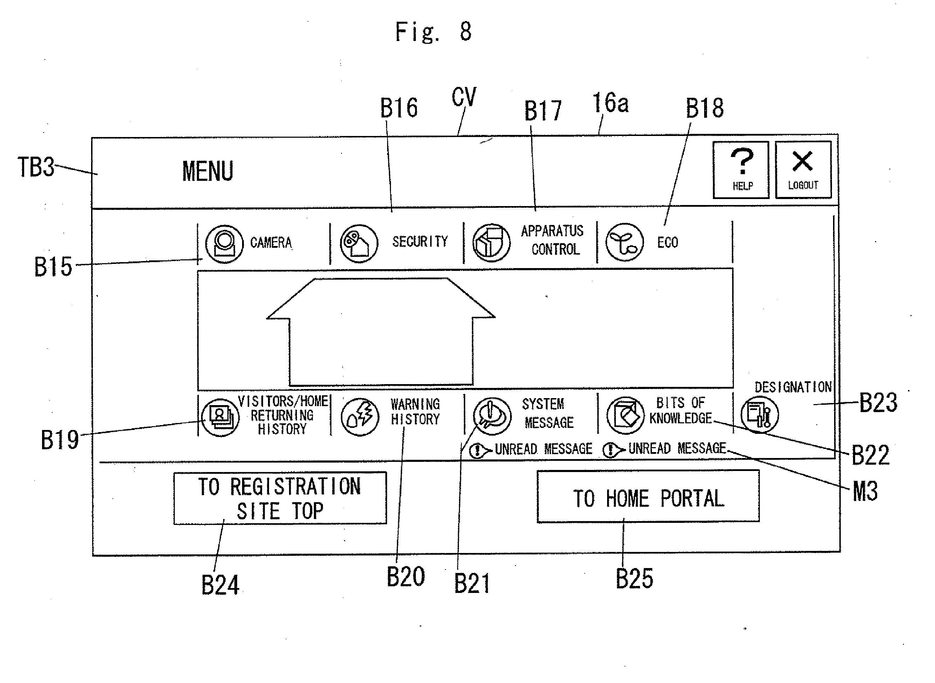

FIG. 8 shows an example of the menu screen provided by the center device **SV.** A title bar **TB3** indicating a screen name (in the present screen, "menu") is displayed in the upper portion of the screen shown in FIG. 8. Menu selection buttons **B15** to **B23** for selecting a desired menu are displayed in the center of the screen shown in FIG. 8. Further, a movement button **B21** for moving to a top page of a registration site and a movement button **B22** for moving to a home portal are displayed in the lower portion of the screen shown in FIG. 8. The text (such as, "Camera", "Apparatus Control", "Eco", and "Bits of Knowledge") that indicates corresponding menu contents is displayed on the respective menu selection buttons **B15** to **B23.** The menu selection button **B22** serves to switch from the screen shown in FIG. 8 to a screen for displaying the bits of knowledge. When an unread message is present, the selection button **B22** is displayed together with a message **M3.** The message **M3** is a message of notifying the user of presence of an unread message.

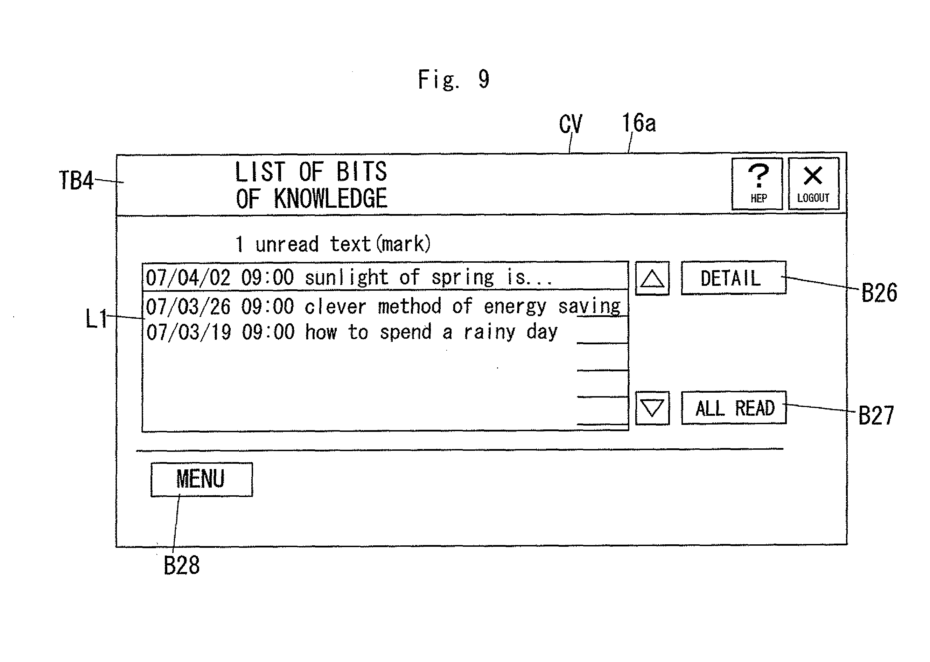

When the selection button **B22** is selected on the screen shown in FIG. 8, a screen (screen for displaying a list of the bits of knowledge) shown in FIG. 9 is displayed on the display screen **16a** by means of processing similar to that described above. A title bar **TB4** indicating a screen name (in the present screen, "List of Bits of Knowledge") is displayed in the upper portion of the screen shown in FIG. 9. A list **L1** displaying the bits of knowledge in date order is displayed in the center of the screen shown in FIG. 9. Further, a menu button **B28** for moving to the screen shown in FIG. 8 is displayed in the lower portion of the screen shown in FIG. 9. Moreover, in the screen shown in FIG. 9, a detail button **B26** and read button **B27** are displayed to the right of the list **L1.** The detail button **B26** is a button for moving to a displaying screen for displaying detail information of each of the bits of knowledge. The read button **B27** is a button for marking all of the bits of knowledge displayed in the list **L1** as read.

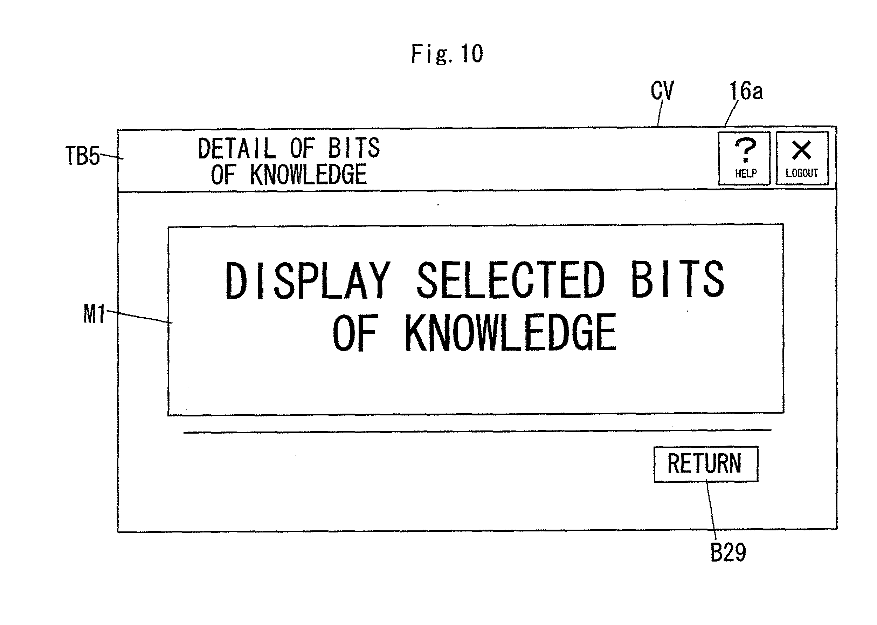

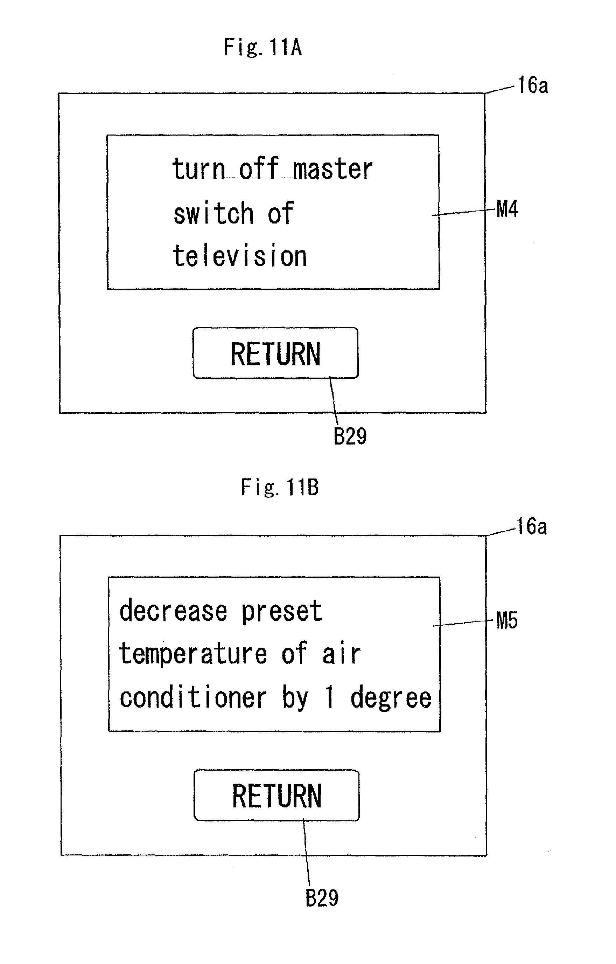

In order to display the detail information of the bits of knowledge displayed in the list **L1,** it is sufficient the user selects the bits of knowledge to view and then selects the detail button **B27** on the screen shown in FIG. 9. In response to this operation, a screen of displaying details of bits of knowledge shown in FIG. 10 is displayed on the display screen **16a** by means of processing similar to that described above. A title bar **TB5** indicating a screen name (in the present screen, "Detail of Bits of Knowledge") is displayed in the upper portion of the screen shown in FIG. 10. A detailed message **M1** in relation to the bits of knowledge selected from the list **L1** in the screen shown in FIG. 9 is displayed in the center of the screen shown in FIG. 10. A message **M4** shown in FIG. 11A and a message **M5** shown in FIG. 11B show a specific example of the message **M1.** Further, a return button **B29** for moving to the screen shown in FIG. 9 is displayed in the lower portion of the screen shown in FIG. 10.

As described in the above, when the terminal device **TU** transmits to the center device **SV** the display request (the aforementioned information request message) to display the screen for displaying the bits of knowledge, the center device **SV** transmits to the terminal device **TU** which has transmitted the display request the webpage including the bits of knowledge. Therefore, the user can view the energy-saving information at any desired time. Although an explanation is made to the instance where the terminal device **TU** is the display control device **CV,** to execute processing similar to that described above is capable of displaying the bits of knowledge on the display screen **16a** even when the terminal device **TU** is the personal computer **PC** or the net television **TV.**

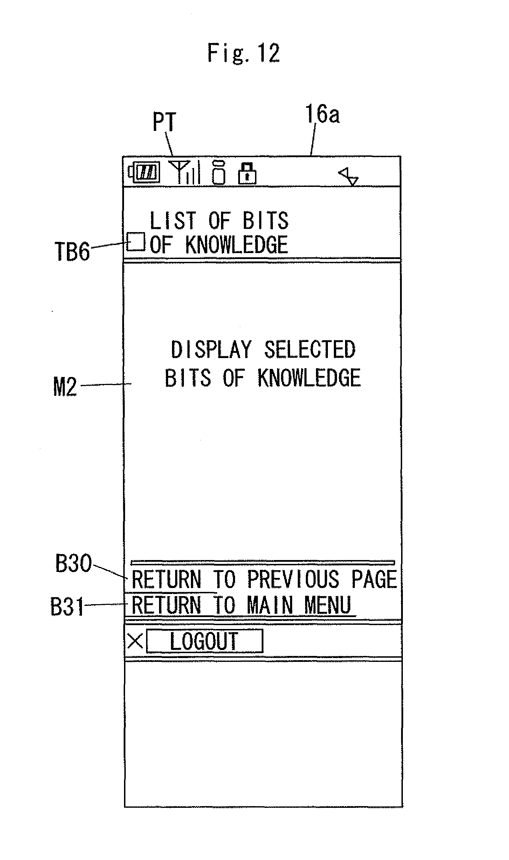

Next, an explanation is made to the instance where the terminal device **TU** is the portable terminal **PT** such as cellular phone. FIG. 12 shows an example of the screen of displaying details of bits of knowledge (corresponding to the screen shown in FIG. 10) of the portable terminal **PT.** A method of displaying the screen shown in FIG. 12 is explained below. First, the user accesses the center server **SV** from the portable terminal **PT** via the internet **NT.** In this case, the control unit **17** of the portable terminal **PT** controls the transmitting-receiving unit **15** so as to transmit a display request to display a menu screen (corresponding to the screen shown in FIG. 8) to the center device **SV** via the internet **NT.** Upon receiving the display request via the internet **NT,** the center device **SV** transmits via the internet **NT** a webpage for displaying the menu screen to the portable terminal **PT** that is a transmission source of the display request. Therefore, the webpage received by the transmitting-receiving unit **15** is displayed on the display screen **16a** of the portable terminal **PT.** Thereafter, when a selection button for switching to a screen (corresponding to the screen shown in FIG. 9) for displaying the list of the bits of knowledge is selected on the menu screen of the portable terminal **PT,** the screen (bits of knowledge list displaying screen) for displaying the list of the bits of knowledge is displayed on the display screen **16a** by means of processing similar to that described above. Further, when the user selects the bits of knowledge to view and then selects a detail button on the bits of knowledge list displaying screen, the bits of knowledge selected by the user is displayed on the display screen **16a** by means of processing similar to that described above.
In addition, a title bar **TB6** indicating a screen name (in the present screen, "List of Bits of Knowledge") is displayed in the upper portion of the screen shown in FIG. 12. A detailed message **M2** in relation to the selected bits of knowledge is displayed in the center of the screen shown in FIG. 12. Further, a return button **B30** for moving to the previous screen and a menu button **B31** for moving to the menu button are displayed in the lower portion of the screen shown in FIG. 12.

Moreover, when new bits of knowledge are present, the center device **SV** may display presence of the new bits of knowledge on, for example, an initial screen (e.g. the screen shown in FIG. 6 or FIG. 8) of the terminal device **TU.** In this instance, the terminal device **TU** displaying a message indicative of the presence of the new bits of knowledge on the display screen **16a** of the image display unit **16** is capable of notifying the user of addition of the new bits of knowledge. Although the bits of knowledge concerning the energy saving is exemplified as the information indicative of the method of the energy saving in the present embodiment, the information indicative of the method of the energy saving may be selected from advice based on the measured electricity usage and the like.

In the above explanation, the center device **SV** transmits the bits of knowledge to the terminal device **TU** in response to the request from the terminal device **TU.** This operation is realized by the pull-type information providing function of the information transmission unit. Meanwhile, the information transmission unit of the center device **SV** of the present embodiment has the push-type information providing function. Therefore, for example, the center device **SV** can transmit periodically (for example, once a week) the energy-saving information to the preliminarily registered terminal device **TU** without any request from the terminal device **TU.** In this case, it is possible to display the energy-saving information on the terminal device **TU** even if the user does not access the center device **SV.** It is noted that an e-mail can be utilized as a method of transmitting the energy-saving information to the terminal device **TU.**

In the present embodiment an example is shown in which the energy management unit **3** and integrated device **TM** are arranged together with the current measurement unit **2** in one integrated control panel **1.** However, the energy management unit **3** and integrated device **TM** may be provided as a control panel separate from the current measurement unit **2.** In this case, the current measurement unit **2** and the energy management unit **3** may be connected by a communication cable.

## Claims

1. An energy management system comprising:
a home appliance located in a home; and
a terminal device connected to said home appliance,
wherein said home appliance comprises a current measurement unit, an electrical energy calculation unit, and a processing unit,
said current measurement unit being configured to measure a current flowing through each branch breaker connected to an output terminal of a main breaker,
said electrical energy calculation unit being configured to calculate electricity usage at each of said branch breakers on the basis of a measurement of said current measurement unit, and
said processing unit being configured to generate information of electricity usage at the home on the basis of the electric usage calculated by said electrical energy calculation unit,
wherein said terminal device comprises a display unit adapted in the use of displaying the information of the electricity usage generated by said processing unit,
wherein said energy management system comprises a server connected to said home appliance via an outside network, and
wherein said server comprises a storage unit and an information transmission unit,
said storage unit being configured to store energy-saving information including information indicative of a method of energy saving, and
said information transmission unit being configured to transmit the energy-saving information stored in said storage unit to said terminal device.

2. An energy management system as set forth in claim 1,
wherein said information transmission unit is configured to transmit the energy-saving information to said terminal device at a prescribed timing.

3. An energy management system as set forth in claim 1,
wherein said information transmission unit is configured to transmit the energy-saving information to said terminal device in response to a request from said terminal device.
